# FASCICULE DE BREVET EUROPEEN

(11) **EP 3 459 121 B1**
(45) Date de publication et mention de la délivrance du brevet: **03.11.2021**
(21) Numéro de dépôt: 17730858.2
(22) Date de dépôt: 18.05.2017
(51) Int. Cl.: H01L 31/05, H01L 31/0224

(54) **ASSEMBLAGE DE CELLULES PHOTOVOLTAIQUES**
ANORDNUNG AUS FOTOVOLTAISCHEN ZELLEN
ARRAY OF PHOTOVOLTAIC CELLS

(30) Priorité: 20.05.2016 FR 1654518
(43) Date de publication de la demande: 27.03.2019
(73) Titulaire: S'Tile, 86180 Buxerolles (FR)
(72) Inventeur: STRABONI, Alain, 86180 Buxerolles (FR); SOW, Alioune, 86280 Saint Benoit (FR); SUN, Guocai, 92340 Bourg La Reine (FR); SUMMHAMMER, Johan, 2102 Bisamberg (AT)
(74) Mandataire: Cabinet Beaumont
(86) Numéro de dépôt international: PCT/FR2017/051217
(87) Numéro de publication internationale: WO 2017/198961

(56) Documents cités:
- EP-A2- 1 868 250
- EP-A2- 2 325 896
- CN-A- 102 403 373
- CN-A- 104 103 698
- DE-A1- 10 056 214
- DE-A1-102008 055 475
- JP-A- 2003 224 289
- JP-A- 2004 281 799
- US-A- 3 459 597
- US-A- 4 574 160
- US-A1- 2007 144 578
- US-A1- 2014 124 014
- Seri: "Basic Photovoltaic Principles and Methods", , 1 February 1982 (1982-02-01), pages 1-69, XP055796427, Retrieved from the Internet: URL:https://www.nrel.gov/docs/legosti/old/ 1448.pdf [retrieved on 2021-04-19]

## Description

La présente demande de brevet revendique la priorité de la demande de brevet français FR16/54518.

### Domaine

La présente invention concerne des dispositifs photovoltaïques, et plus particulièrement des dispositifs photovoltaïques composés de plusieurs cellules photovoltaïques.

### Exposé de l'art antérieur

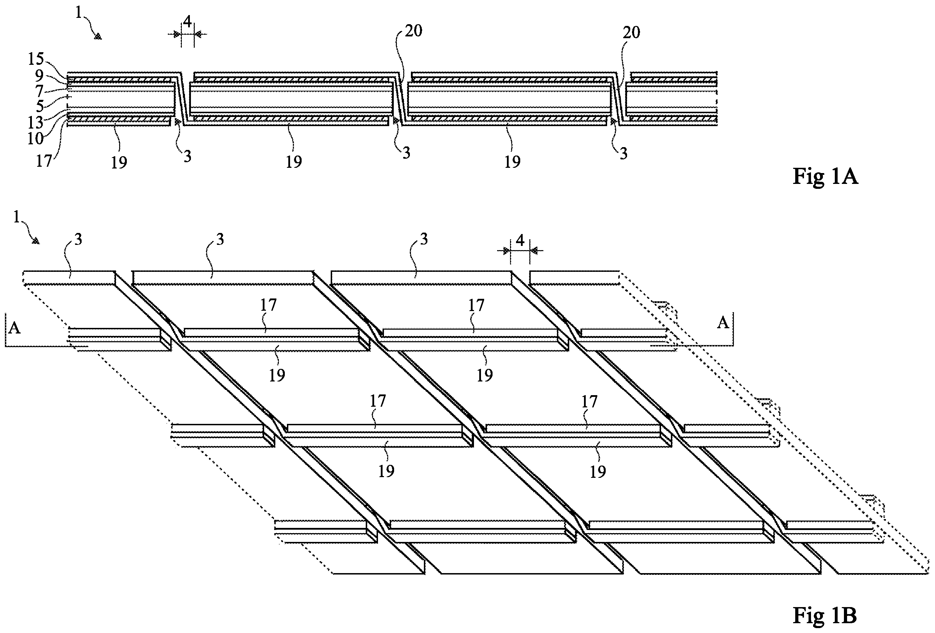

Les figures 1A et 1B représentent schématiquement un assemblage 1 de cellules 3 d'un panneau photovoltaïque classique. La figure 1A est une coupe selon le plan A-A de la figure 1B. La figure 1B est une vue partielle en perspective de la face arrière du panneau.

Les cellules photovoltaïques 3 sont en forme de plaques rectangulaires et sont disposées côte à côte dans un même plan. Les cellules voisines ont leurs grands côtés en vis-à-vis séparés d'une distance 4. La dimension des grands côtés, ou largeur de l'assemblage, est typiquement comprise entre 51 mm (environ 2 pouces) et 210 mm (environ 8 pouces), par exemple de l'ordre de 156 mm (environ 6 pouces). Les petits côtés des cellules ont typiquement des dimensions comprises entre un dixième de la largeur de l'assemblage et la largeur de l'assemblage.

Chaque cellule 3 comprend une plaque semiconductrice 5 par exemple en silicium, par exemple dopé de type P. Une couche 7 dopée de type N s'étend dans la plaque 5 à partir de la face avant. La couche 7 peut être structurée de façon à piéger la lumière du soleil et recouverte d'une couche antireflet non représentée. Des structures collectrices 9 et 10, conductrices, non représentées en détail, sont situées respectivement sur les faces avant et arrière de la cellule.

A titre d'exemple, la structure collectrice 9 en face avant est en forme de peigne dont les dents forment avec la couche 7 des contacts électriques régulièrement répartis sur la face. La structure collectrice 9 permet à la lumière du soleil d'accéder à la face avant entre les dents du peigne. La structure collectrice 9 peut aussi être une couche d'un matériau conducteur transparent, par exemple en oxyde d'étain et d'indium.

La structure collectrice 10 en face arrière est en contact avec la plaque 5 par l'intermédiaire d'une région 13 plus fortement dopée de type P que la plaque 5. A titre d'exemple, la structure 10 est une couche d'aluminium, et la région 13 résulte d'une diffusion de l'aluminium dans la plaque 5. Au besoin, si on souhaite que la face arrière du panneau recueille elle aussi de la lumière, par exemple la lumière issue de surfaces claires ou réfléchissantes disposées à l'arrière du panneau, la structure collectrice 10 peut être similaire à la structure collectrice 9.

Les structures collectrices 9 et 10 sont munies de bandes de connexion respectives 15 et 17 en argent disposées sur les faces des cellules. Les bandes de connexion de chaque cellule s'étendent d'un grand côté à l'autre de la cellule dans le sens de la longueur de l'assemblage. Chaque cellule est munie sur chaque face de bandes de connexion réparties régulièrement, par exemple 3 bandes de connexion.

Les cellules sont connectées en série par des rubans conducteurs 19, par exemple en cuivre. Chaque ruban s'étend dans le sens de la longueur de l'assemblage. Chaque ruban est soudé d'une part à une bande de connexion 17 sur la face arrière d'une cellule et d'autre part à une bande de connexion 15 sur la face avant d'une cellule voisine. Les soudures peuvent comprendre un alliage à base d'étain situé entre les rubans et les bandes de connexion, destiné à faciliter l'opération de soudage. Aux extrémités de la répétition de cellules, non représentées, les bandes de connexion des cellules d'extrémité sont reliées à d'autres assemblages similaires connectés en série ou en parallèle avec l'assemblage 1 ou sont reliées à des dispositifs électroniques tels que des convertisseurs.

En fonctionnement, lorsque les cellules sont exposées à la lumière du soleil, le courant produit par chaque cellule est collecté en face arrière par la structure collectrice 10, converge vers les bandes 17 et chemine dans les rubans 19 vers les bandes 15 de la cellule voisine. Le courant est réparti sur la face avant de cette cellule voisine par la structure 9.

Lorsque le panneau photovoltaïque est éclairé par le soleil, sa température peut atteindre 90°C. Lorsque le temps est couvert, ou la nuit, la température du panneau reste proche de la température extérieure. Ainsi, les éléments constituant le panneau se dilatent et se contractent thermiquement au rythme des journées et des passages nuageux. Outre ces déformations thermiques, le panneau peut subir d'autres déformations, liées aux caprices de la météo. Par exemple, le poids de la neige ou la force du vent peuvent déformer le panneau.

On constate que des panneaux photovoltaïques comprenant des assemblages tels que décrits ci-dessus ont une durée de vie limitée ou présentent au cours du temps une diminution de puissance. En outre, au cours du processus de fabrication de panneaux photovoltaïques à partir d'assemblages tels que décrits ci-dessus, les assemblages sont soumis à des températures pouvant atteindre 180°C. On constate que ces panneaux photovoltaïques peuvent présenter des problèmes de fonctionnement et doivent être rejetés, ce qui limite le rendement de fabrication.

Les documents US2007/144578A1, US4574160A et XP055796427 (intitulé "Basic Photovoltaic Principles and Methods", février 1982, p. 1-69) décrivent des exemples d'assemblages de cellules photovoltaïques.

### Résumé

Un mode de réalisation prévoit un dispositif photovoltaïque palliant tout ou partie des inconvénients décrits ci-dessus.

Un mode de réalisation prévoit un dispositif photovoltaïque pouvant subir des variations de température ou être déformé ou courbé tout en conservant une grande durée de vie.

Ainsi, l'invention prévoit un dispositif photovoltaïque selon la revendication 1.

Selon un mode de réalisation, la distance entre cellules est inférieure à cinq fois l'épaisseur du ruban.

Selon un mode de réalisation, chaque cellule comprend des encoches latérales propres à recevoir des parties sensiblement verticales des rubans, d'où il résulte que des cellules adjacentes peuvent être mises en butée.

Selon un mode de réalisation, les premiers et deuxièmes plots de connexion ont des dimensions latérales inférieures à 3 mm.

Selon un mode de réalisation, les cellules voisines sont séparées d'une distance inférieure au double de l'épaisseur des rubans.

Selon un mode de réalisation, les premiers plots de connexion sont disposés sur des premières structures collectrices en forme de peigne.

Selon un mode de réalisation, les premiers plots de connexion sont disposés sur des premières structures collectrices en forme de feuilles, les premiers plots étant situés sur les pétioles des feuilles.

Selon un mode de réalisation, les premiers plots de connexion sont disposés sur des premières structures collectrices en forme d'arborescences, les premiers plots étant situés sur les bases des arborescences.

Selon un mode de réalisation, les deuxièmes plots sont disposés sur des deuxièmes structures collectrices similaires aux premières structures collectrices.

Selon un mode de réalisation, les rubans sont des rubans de cuivre.

Un mode de réalisation prévoit un produit intermédiaire selon la revendication 11, comprenant une plaque photovoltaïque comportant une juxtaposition de cellules, destinée à être découpée en cellules individuelles, la plaque photovoltaïque ayant une forme carrée dont les côtés ont une dimension comprise entre 125 et 210 mm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B représentent schématiquement un assemblage de cellules photovoltaïques ;
les figures 2A et 2B représentent schématiquement un mode de réalisation d'un assemblage de cellules photovoltaïques ;
la figure 3 illustre un mode de réalisation d'une structure collectrice et de plots de connexion ;
la figure 4 illustre un autre mode de réalisation d'une structure collectrice ; et
la figure 5 représente un produit intermédiaire permettant d'obtenir des cellules photovoltaïques.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, sauf précision contraire, les expressions "environ" et "de l'ordre de" signifient à 10 % près, de préférence à 5 % près.

Dans la présente description, on appelle "longueur" d'un élément d'un assemblage de cellules la dimension de cet élément dans le sens de la longueur de rubans de connexions de l'assemblage. La largeur de cet élément désigne sa dimension dans la direction perpendiculaire. Lorsqu'un élément de l'assemblage est dit "horizontal" ou "oblique", il est fait référence à l'orientation de l'élément concerné dans les vues en coupe.

Dans la présente description, deux éléments sont dits "soudés" lorsque la continuité mécanique et électrique entre ces éléments est assurée par une soudure pouvant comprendre ou non un matériau d'apport tel qu'un matériau de brasage.

L'inventeur a constaté que, lorsqu'un panneau photovoltaïque classique du type illustré en figures 1A et 1B est soumis à des déformations répétées, des ruptures par fatigue peuvent se produire et limiter la durée de vie du panneau. Ces ruptures ont deux causes principales.

D'une part, les portions obliques 20 non soudées des rubans 19, situées entre les bandes de connexion 15 et 17, sont les éléments les moins rigides de l'ensemble du panneau et absorbent la plupart des déformations. Or, ces portions obliques ont une longueur faible par rapport aux longueurs des cellules. Ces déformations sur de faibles longueurs provoquent des contraintes dont la répétition est délétère.

D'autre part, lors de variations de température, les différents matériaux de la plaque 5, des bandes de connexion 15 et 17 et du ruban 19 se dilatent différemment. Ces éléments étant soudés les uns aux autres sur toute la longueur d'une cellule, des contraintes importantes apparaissent. Ces contraintes créent des ruptures de connexions ou des défauts tels que des microfissures dans les parties de la plaque proches des soudures.

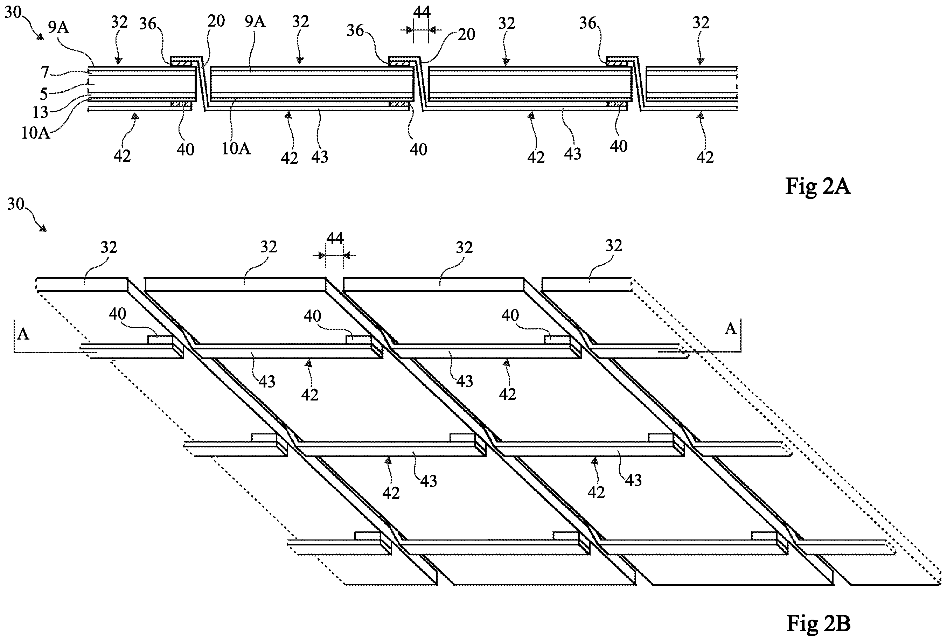

Les figures 2A et 2B représentent schématiquement un mode de réalisation d'un assemblage 30 de cellules 32 d'un panneau photovoltaïque. La figure 2A est une coupe partielle de l'assemblage 30 selon le plan A-A de la figure 2B. La figure 2B est une vue en perspective de la face arrière de l'assemblage 30.

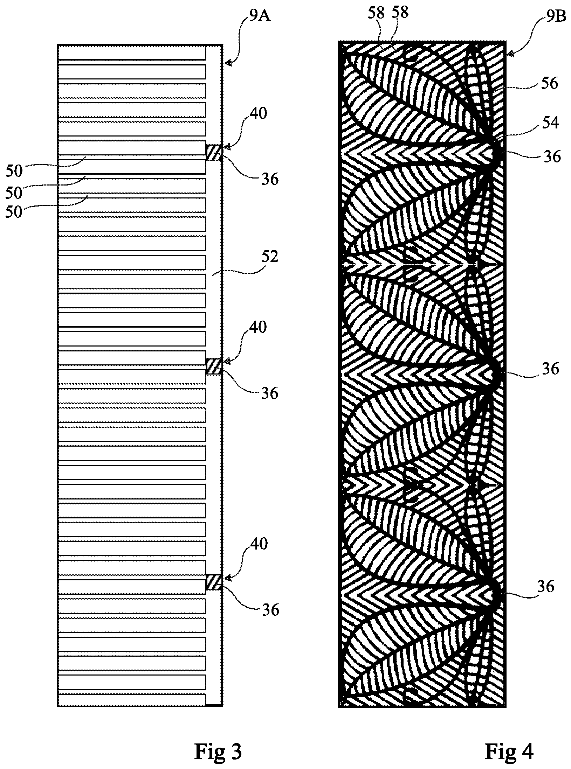

Chaque cellule 32 comprend comme précédemment une plaque semiconductrice 5 dopée de type P munie en face avant d'une couche 7 dopée de type N. L'épaisseur de la plaque peut être comprise entre environ 150 µm et environ 200 µm. Des structures collectrices 9A et 10A, dont des exemples seront donnés en relation avec les figures 3 et 4, sont situées respectivement sur les faces avant et arrière de la cellule. La structure collectrice 10A est en contact avec la plaque 5 par l'intermédiaire d'une région 13 plus fortement dopée de type P que la plaque.

La structure collectrice 9A est munie de plots de connexion 36 (non visibles en figure 2B) et peut avoir une forme de peigne. La structure collectrice 10A, non détaillée en figure 2B, est munie de plots de connexion 40. La structure collectrice 10A est par exemple une couche d'aluminium continue et donc opaque ou peut être partiellement ajourée et ainsi laisser passer la lumière. Les plots de connexion 36 et 40 peuvent être par exemple à base d'argent et/ou d'étain. Les plots sont alignés dans le sens de la largeur de chaque cellule.

Les dimensions latérales des plots de connexion 36 et 40 sont petites par rapport à celles des cellules. Les plots de connexion 36 et 40 ont des longueurs et des largeurs inférieures à 10 % de la longueur des cellules. Les longueurs et les largeurs des plots 36 et 40 sont par exemple inférieures à 3 mm.

Des rubans conducteurs 42, par exemple en cuivre, s'étendent à partir de chaque plot 40. Chaque ruban 42 a une extrémité soudée à un plot 40 et son autre extrémité soudée à un plot 36 d'une cellule voisine. La largeur des rubans est comprise entre 1 et 3 mm. L'épaisseur des rubans est comprise entre 50 et 200 µm. A titre d'exemple, deux cellules voisines sont reliées par trois rubans 42 parallèles disposés régulièrement.

Les plots 40 de chaque cellule sont disposés près du bord le plus éloigné de la cellule voisine à laquelle ces plots sont connectés par des rubans 42. Les plots 40 de chaque cellule se trouvent ainsi dans la moitié de la cellule la plus éloignée de la cellule voisine connectée à ces plots. Chaque plot 40 d'une cellule 32 est situé en totalité dans les 10 % de la cellule 32 les plus éloignés de la cellule voisine connectée au plot. Les plots 36 sont disposés en regard des plots 40.

Du fait de cette disposition des plots 40, chaque ruban 42 a, en plus d'une partie oblique 20, une partie libre horizontale 43 non soudée dont la longueur est supérieure à la moitié de la longueur des cellules. La longueur de cette partie libre horizontale est de l'ordre de la longueur des cellules.

On notera que, dans le mode de réalisation des figures 2A et 2B, les plots et les soudures ont des petites dimensions. Il en résulte un premier avantage qui est que les différences de dilatation entre les divers éléments produisent des contraintes négligeables.

Par ailleurs, les parties libres horizontales 43 ont des longueurs beaucoup plus grandes que les parties obliques 20 qui étaient les seules parties libres dans l'assemblage des figures 1A et 1B. Il en résulte un deuxième avantage qui est que le panneau photovoltaïque peut supporter sans inconvénient des déformations dues par exemple à des variations de température, à la force du vent et au poids de la neige.

Il en résulte un troisième avantage, qui est que, comme on n'a plus à assurer une possibilité de déformation suffisante pour la partie oblique 20, la distance 44 entre cellules voisines des figures 2A et 2B peut être par exemple de moins de cinq fois, voire deux fois, l'épaisseur des rubans, alors que dans l'assemblage des figures 1A et 1B la distance 4 entre cellules devait être d'au moins 10 fois l'épaisseur des rubans. La surface de panneau située entre les cellules, inutilisée pour capter la lumière, est alors faible et le rendement du panneau est élevé. Du fait qu'un panneau peut comprendre par exemple plusieurs centaines de cellules, le gain en surface active est non négligeable. La puissance produite par unité de surface du panneau est donc supérieure à celle d'un panneau classique du type de la figure 1. En outre, les rubans 42 n'occultent pas la face avant en dehors des plots de connexion 36, et ceci permet d'obtenir un panneau produisant une puissance élevée.

On pourra en outre prévoir, dans chaque cellule ou dans chaque couple de cellules adjacentes, une encoche ayant une largeur et une profondeur propres à contenir la partie oblique (maintenant sensiblement verticale) de chaque ruban. On pourra alors mettre les cellules en butée, ce qui réduit encore l'encombrement total du panneau.

La figure 3 illustre, à titre d'exemple, une structure collectrice 9A en face avant d'une cellule 32. La structure collectrice 9A a une forme de peigne. Les dents 50 du peigne sont reliées à une bande 52 qui s'étend le long d'un grand côté de la cellule. Les dents sont réparties régulièrement et s'étendent jusqu'au grand côté opposé à la bande 52. Les dents ont par exemple une largeur comprise entre 50 et 100 µm et ont un pas compris entre 1 et 3 mm. La structure collectrice 9A peut être par exemple en argent ou en aluminium. La structure collectrice 9A peut avoir une épaisseur comprise entre 10 et 30 µm. Des portions de couches de protection et/ou de couches antireflets peuvent être présentes sur la couche dopée 7 entre les dents du peigne.

La bande 52 du peigne est munie de trois plots de connexion 36 régulièrement répartis. Chaque plot 36 est situé en totalité sur la bande 52. Des plots 40, non visibles, sont situés par exemple sous les plots 36.

La figure 4 illustre un autre exemple de structure collectrice 9B en face avant d'une cellule. La structure 9B peut remplacer la structure collectrice 9A dans la cellule 32. La structure 9B comprend une répétition, dans le sens de la largeur, de sous-structures en forme de feuilles reliées aux plots de connexion 36. Chaque plot de connexion est associé à deux sous-structures symétriques. Chaque sous-structure comprend un pétiole 54 qui part du plot et se divise en nervures principales 56 de formes courbées. Les nervures principales 56 s'éloignent du plot en ayant une dimension latérale qui diminue. Des groupes de trois nervures principales peuvent avoir leurs extrémités qui se rejoignent et les nervures peuvent ainsi dessiner des feuilles. Les nervures principales sont reliées à des nervures secondaires 58 régulièrement espacées. Les nervures secondaires peuvent être courbes à l'intérieur des feuilles et rectilignes à l'extérieur des feuilles. Dans une variante non représentée, les extrémités des nervures principales ne se rejoignent pas. La structure collectrice comprend alors une répétition de sous-structures en forme d'arborescences dont les bases correspondent aux pétioles.

En fonctionnement, la part de lumière solaire accédant à la face avant au travers de la structure collectrice 9B est plus grande qu'au travers de la structure collectrice 9A. La structure collectrice 9B permet ainsi d'obtenir un panneau photovoltaïque de rendement élevé.

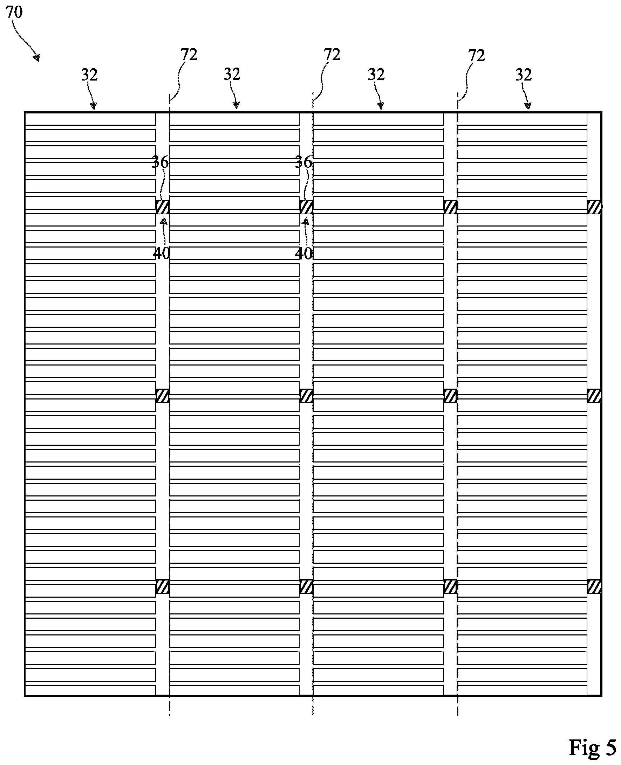

La figure 5 représente un produit intermédiaire permettant d'obtenir des cellules 32 du type décrit précédemment. Le produit intermédiaire comprend une plaque photovoltaïque 70, de forme par exemple carrée. Les dimensions des côtés de la plaque peuvent être comprises entre 125 mm (environ 5 pouces) et 210 mm (environ 8 pouces). La plaque 70 correspond à des cellules 32 juxtaposées réunies par leurs grands côtés et destinées à être séparées au cours d'une étape de découpe selon des lignes de découpe 72. Les faces avant des cellules sont orientées dans le même sens. La plaque comprend en particulier les plots de connexion 36 et les plots 40 définis précédemment.

Des modes de réalisation particuliers ont été décrits. Diverses variantes et modifications apparaîtront à l'homme de l'art. En particulier, bien que des formes particulières de structures collectrices aient été décrites, on peut utiliser sur les faces des cellules toute structure collectrice laissant passer la lumière et pouvant collecter un courant sur une face et diriger ce courant vers des plots de connexion.

De plus, dans les modes de réalisation décrits, la distance entre chaque plot 40 situé en face arrière et la cellule voisine connectée au plot est supérieure à la moitié de la longueur de la cellule. La distance entre chaque plot de connexion 36 situé en face avant et la cellule connectée au plot 40 peut également être supérieure à la moitié de la longueur de la cellule, par exemple supérieure à 90 % de la longueur de la cellule. Les longueurs libres des rubans qui connectent les cellules peuvent alors être de l'ordre du double de la longueur d'une cellule, ce qui accroit encore la résistance de l'assemblage aux déformations.

Bien que les cellules décrites comprennent des plaques semiconductrices dopées de type P ayant chacune en face avant une couche dopée de type N, les cellules peuvent aussi comprendre des plaques semiconductrices dopées de type N munies chacune en face avant d'une couche dopée de type P.

En outre, la plaque semiconductrice peut être mono-cristalline ou multicristalline.

En ce qui concerne le procédé de fabrication de la structure, on pourra prévoir que les soudures de face arrière entre les rubans et les plots de connexion soient réalisées par chauffage à partir de la face avant.

## Revendications

1. Dispositif photovoltaïque comprenant une juxtaposition de cellules (32), côte à côte dans un même plan, connectées en série par des rubans conducteurs (42 ; 62), chaque ruban étant soudé d'une part à un premier plot de connexion (36) en face avant d'une première cellule et d'autre part à un deuxième plot de connexion (40) en face arrière d'une deuxième cellule voisine de la première cellule, le deuxième plot étant entièrement situé dans les 10 % de la deuxième cellule les plus éloignés de la première cellule, et chaque ruban comportant, entre le premier plot de connexion (36) de la première cellule et le deuxième plot de connexion (40) de la deuxième cellule, une partie libre horizontale non soudée de l'ordre de la longueur des cellules,
dans lequel les premiers (36) et deuxièmes (40) plots ont des longueurs et des largeurs inférieures à 10 % de la longueur des cellules,
dans lequel les rubans (42 ; 62) ont une largeur comprise entre 1 et 3 mm et une épaisseur comprise entre 50 et 200 µm,
et dans lequel le premier plot est situé en regard du deuxième plot.

2. Dispositif selon la revendication 1, dans lequel la distance entre cellules est inférieure à cinq fois l'épaisseur du ruban.

3. Dispositif selon la revendication 1, dans lequel chaque cellule comprend des encoches latérales propres à recevoir des parties sensiblement verticales des rubans, d'où il résulte que des cellules adjacentes peuvent être mises en butée.

4. Dispositif selon l'une quelconque des revendications 1 à 3, dans lequel les premiers (36) et deuxièmes (40) plots de connexion ont des dimensions latérales inférieures à 3 mm.

5. Dispositif selon l'une quelconque des revendications 1 à 4, dans lequel les cellules voisines sont séparées d'une distance inférieure au double de l'épaisseur des rubans (42 ; 62).

6. Dispositif selon l'une quelconque des revendications 1 à 5, dans lequel les premiers plots de connexion (36) sont disposés sur des premières structures collectrices (9A) en forme de peigne.

7. Dispositif selon l'une quelconque des revendications 1 à 5, dans lequel les premiers plots de connexion sont disposés sur des premières structures collectrices (9B) en forme de feuilles, les premiers plots étant situés sur les pétioles (54) des feuilles.

8. Dispositif selon l'une quelconque des revendications 1 à 5, dans lequel les premiers plots de connexion sont disposés sur des premières structures collectrices en forme d'arborescences, les premiers plots étant situés sur les bases des arborescences.

9. Dispositif selon l'une quelconque des revendications 6 à 8, dans lequel les deuxièmes plots (40) sont disposés sur des deuxièmes structures collectrices similaires aux premières structures collectrices.

10. Dispositif selon l'une quelconque des revendications 1 à 9, dans lequel les rubans (42 ; 62) sont des rubans de cuivre.

11. Produit intermédiaire comprenant une plaque photovoltaïque (70) comportant une juxtaposition de cellules (32) destinée à être découpée en cellules individuelles, chaque cellule (32) comportant, un premier plot de connexion (36) en face avant et un deuxième plot de connexion (40) en face arrière de la cellule, le premier plot (36) étant situe en regard du deuxième plot (40), le deuxième plot étant situé dans les 10% de la cellule les plus éloignés d'une cellule voisine, le première plot (36) et le deuxième plot (40) ayant des longueurs et des largeurs inférieurs à 10 % de la longueur de la cellule, et la plaque photovoltaïque ayant une forme carrée dont les côtés ont une dimension comprise entre 125 et 210 mm.

## Patentansprüche

1. Photovoltaische Vorrichtung mit einer Aneinanderreihung von Zellen (32), die nebeneinander in derselben Ebene liegen und durch Leiterbahnen (42; 62) in Reihe geschaltet sind, wobei jede Bahn einerseits mit einer ersten Anschlussfläche (36) auf der Vorderseite einer ersten Zelle und andererseits mit einer zweiten Anschlussfläche (40) auf der Rückseite einer zweiten Zelle in der Nähe der ersten Zelle verschweißt ist, wobei sich die zweite Anschlussfläche vollständig in den 10 % der zweiten Zelle befindet, die am weitesten von der ersten Zelle entfernt sind, und wobei jede Bahn zwischen der ersten Anschlussfläche (36) der ersten Zelle und der zweiten Anschlussfläche (40) der zweiten Zelle einen nicht verschweißten horizontalen freien Abschnitt mit einer Länge in der Größenordnung der Länge der Zellen aufweist,
wobei die ersten Anschlussflächen (36) und die zweiten Anschlussflächen (40) eine Länge und Breite von weniger als 10 % der Zellenlänge aufweisen,
wobei die Bahnen (42; 62) eine Breite zwischen 1 und 3 mm und eine Dicke zwischen 50 und 200 µm aufweisen,
und wobei die erste Anschlussfläche gegenüber der zweiten Anschlussfläche angeordnet ist.

2. Vorrichtung nach Anspruch 1, wobei der Abstand zwischen den Zellen kleiner als das Fünffache der Leiterbahndicke ist.

3. Vorrichtung nach Anspruch 1, wobei jede Zelle seitliche Kerben aufweist, die in der Lage sind, im Wesentlichen vertikale Teile der Bahnen aufzunehmen, wodurch benachbarte Zellen aneinanderstoßen können.

4. Vorrichtung nach einem der Ansprüche 1 bis 3, wobei die erste (36) und die zweite (40) Anschlussfläche seitliche Abmessungen von weniger als 3 mm aufweisen.

5. Vorrichtung nach einem der Ansprüche 1 bis 4, wobei benachbarte Zellen durch einen Abstand getrennt sind, der kürzer als die doppelte Dicke der Bahnen (42; 62) ist.

6. Vorrichtung nach einem der Ansprüche 1 bis 5, wobei die ersten Anschlussflächen (36) auf ersten kammförmigen Kollektorstrukturen (9A) angeordnet sind.

7. Vorrichtung nach einem der Ansprüche 1 bis 5, bei der die ersten Anschlusspads an ersten blattförmigen Kollektorstrukturen (9B) angeordnet sind, wobei sich die ersten Anschlussflächen an den Blattstielen (54) der Blätter befinden.

8. Vorrichtung nach einem der Ansprüche 1 bis 5, bei der die ersten Anschlusspads an ersten baumförmigen Kollektorstrukturen angeordnet sind, wobei die ersten Anschlussflächen an den Basen der Baumstrukturen angeordnet sind.

9. Vorrichtung nach einem der Ansprüche 6 bis 8, wobei die zweiten Anschlussflächen (40) an zweiten Kollektorstrukturen angeordnet sind, die den ersten Kollektorstrukturen ähnlich sind.

10. Vorrichtung nach einem der Ansprüche 1 bis 9, wobei die Bahnen (42; 62) aus Kupfer bestehen.

11. Zwischenprodukt mit einer photovoltaischen Platte (70), die eine Aneinanderreihung von Zellen (32) aufweist, die in einzelne Zellen geschnitten werden sollen, wobei jede Zelle (32) Folgendes aufweist,
eine erste Anschlussfläche (36) auf der Vorderseite und eine zweite Anschlussfläche (40) auf der Rückseite der Zelle, wobei die erste Anschlussfläche (36) gegenüber der zweiten Anschlussfläche (40) angeordnet ist, die zweite Anschlussfläche in den 10 % der zweiten Zelle, die am weitesten von einer benachbarten Zelle entfernt sind, angeordnet ist, und die erste Anschlussfläche (36) und die zweite Anschlussfläche (40) eine Länge und Breite von weniger als 10 % der Zellenlänge haben, und
wobei die photovoltaische Platte, die eine quadratische Form mit Seiten aufweist, die eine Abmessung im Bereich von 125 bis 210 mm haben.

## Claims

1. A photovoltaic device comprising a juxtaposition of cells (32), side by side in a same plane, series-connected by conductive bands (42; 62), each band being welded on the one hand to a first connection pad (36) on the front surface of a first cell and on the other hand to a second connection pad (40) on the rear surface of a second cell close to the first cell, the second pad being entirely located in the 10 % of the second cell most distant from the first cell, and each band comprising, between the first connection pad (36) of the first cell and the second connection pad (40) of the second cell, a non-welded horizontal free portion having a length in the order of the cells length,
wherein the first pads (36) and second pads (40) have length and width lower than 10% of the cells length,
wherein the bands (42 ; 62) have a width comprised between 1 and 3 mm and a thickness comprised between 50 and 200 µm
and wherein the first pad is located opposite the second pad.

2. The device of claim 1, wherein the distance between cells is smaller than five times the band thickness.

3. The device of claim 1, wherein each cell comprises lateral notches capable of receiving substantially vertical portions of the bands, whereby adjacent cells can be abutted.

4. The device of any of claims 1 to 3, wherein the first (36) and second (40) connection pads have lateral dimensions smaller than 3 mm.

5. The device of any of claims 1 to 4, wherein neighboring cells are separated by a distance shorter than twice the thickness of the bands (42; 62).

6. The device of any of claims 1 to 5, wherein the first connection pads (36) are arranged on first comb-shaped collector structures (9A).

7. The device of any of claims 1 to 5, wherein the first connection pads are arranged on first leaf-shaped collector structures (9B), the first pads being located on the petioles (54) of the leaves.

8. The device of any of claims 1 to 5, wherein the first connection pads are arranged on first tree-shaped collector structures, the first pads being located on the bases of the tree structures.

9. The device of any of claims 6 to 8, wherein the second pads (40) are arranged on second collector structures similar to the first collector structures.

10. The device of any of claims 1 to 9, wherein the bands (42; 62) are copper.

11. An intermediate product comprising a photovoltaic plate (70) comprising a juxtaposition of cells (32) intended to be cut into individual cells, each cell (32) comprising,
a first connection pad (36) on the front surface and a second connection pad (40) on the rear surface of the cell, the first pad (36) being located opposite the second pad (40), the second pad being located in the 10 % of the second cell most distant from an adjacent cell, the first pad (36) and the second pad (40) having length and width lower than 10 % of cell length, and
the photovoltaic plate having a square shape with sides having a dimension in the range from 125 to 210 mm.
